# EUROPÄISCHE PATENTSCHRIFT

(11) **EP 0 777 955 B1**
(45) Veröffentlichungstag und Bekanntmachung des Hinweises auf die Patenterteilung: **20.01.1999**
(21) Anmeldenummer: 95928995.0
(22) Anmeldetag: 28.08.1995
(51) Int. Cl.: H05K 3/20, H01R 13/66

(54) **GERÄT MIT EINER ELEKTRISCHEN SCHALTUNGSANORDNUNG**
DEVICE WITH AN ELECTRIC CIRCUIT
APPAREIL COMPORTANT UNE CIRCUITERIE ELECTRIQUE

(30) Priorität: 30.08.1994 DE 4430798
(43) Veröffentlichungstag der Anmeldung: 11.06.1997
(73) Patentinhaber: SIEMENS AKTIENGESELLSCHAFT, 80333 München (DE)
(72) Erfinder: DIRMEYER, Josef, D-92439 Bodenwöhr (DE); PLANKL, Christian, D-93055 Burgweinting (DE); SWART, Marten, D-93083 Obertraubling (DE); GOTTLIEB, Alfred, D-93152 Nittendorf/Undorf (DE)
(86) Internationale Anmeldenummer: DE9501148
(87) Internationale Veröffentlichungsnummer: WO9607302

(56) Entgegenhaltungen:
- EP-A- 0 241 675
- EP-A- 0 312 415
- EP-A- 0 387 845
- DE-A- 3 142 263
- DE-U- 9 300 869
- FR-A- 2 356 247
- FR-A- 2 361 007
- US-A- 3 810 300
- US-A- 3 978 375

## Beschreibung

Die Erfindung betrifft ein Gerät mit einer elektrischen Schaltungsanordnung gemäß Oberbegriff des Patentanspruchs 1.

Die Verwendung von Stanzgittern als Ersatz für herkömmliche Leiterplatten ist aufgrund niedrigerer Herstellungskosten dann von Vorteil, wenn nur wenige elektrische Bauelemente elektrisch leitend miteinander verbunden werden, insbesondere wenn es sich bei den Bauelementen selbst schon um hochintegrierte Schaltungen handelt.

Aus der Patentschrift US 3 697 816 ist ein Gerät mit einer elektrischen Schaltungsanordung bekannt, bei dem ein aus einem Metallband gestanztes Stanzgitter elektrische Bauelemente elektrisch leitend miteinander verbindet. Dieses Stanzgitter kann zusammen mit einer elektrischen Steckverbindung - wie z.B. mit elektrischen Anschlußstiften - in einem Gehäuse vergossen oder befestigt werden.

Die Herstellung eines solchen Geräts mit einem Stanzgitter zur Verbindung von elektrischen Bauelementen und mit einem Steckerteil mit Anschlußstiften erfordert insbesondere zur Ausbildung des Steckerteils und zur Verbindung der Anschlußstifte des Steckerteils mit dem Stanzgitter eine Vielzahl von Herstellungsschritten.

In der Offenlegungsschrift DE 36 11 224 ist ein Stanzgitter beschrieben, bei dem zumindest Bereiche über Kunststoffbrücken miteinander verbunden sind, sodaß Leiterbahnen des Stanzgitters in ihrer gegenseitigen räumlichen Lage fixiert sind und Leiterbahnen mit unterschiedlichem Potential voneinander isoliert sind. Dieses Stanzgitter verbindet jedoch nicht elektrische Bauelemente miteinander. Es ist als Einlegeteil für ein Gehäuse konzipiert, das ein Steckerteil mit elektrischen Anschlußstiften mit einer herkömmlichen Leiterplatte verbindet. Dazu weist das Einlegeteil Kontaktflächen auf, die als Bondpads für eine Bondverbindung zwischen dem Einlegeteil und der Leiterplatte dienen. Die Anschlußstifte des Steckerteils sind als gesondert von dem Stanzgitter ausgebildete Stifte über Nietverbindungen am Stanzgitter angeordnet.

Die gattungsbildende EP-A-0 387 845 offenbart ein Stanzgitter als Leiterplatte mit einstückig mit dem Stanzgitter ausgebildeten Steckerstiften. Das Stanzgitter ist kunststoffumspritzt. Im Kunststoffmantel sind Aussparungen zur Aufnahme von Gegensteckern vorgesehen.

Aus der US 3 978 375 ist ebenfalls ein Stanzgitter mit einer elektronischen Schaltungsanordnung offenbart. Einzelne Leiterzüge des Stanzgitters sind über Kunststoffbrücken miteinander verbunden. Dazu weisen einzelne Leiterzüge kleinflächige, umgebogene Randbereiche auf, die das Haften der Kunststoffbrücken an den Leiterzügen verbessern sollen.

Aus der FR-A-2 356 247 ist ein Flachkabel bekannt, bei dem einzelne aus einem Blech ausgestanzte Leiterzüge kunststoffumspritzt sind. Die Leiterzüge weisen an Anschlußstellen einen dickeren Querschnitt als im flexibel ausgebildeten Mittelbereich des Kabels auf.

Aufgabe der vorliegenden Erfindung ist es, ein Gerät mit einer elektrischen Schaltungsanordnung zu schaffen, das die Schaltungsanordnung wirksam vor elektromagnetischer Einstrahlung schützt.

Die Aufgabe wird durch die Merkmale des Patentanspruchs 1 gelöst.

Vorteilhafte Weiterbildungen der Erfindung sind in den Unteransprüchen gekennzeichnet.

Ausführungsbeispiele der Erfindung werden anhand der Zeichnung erläutert. Es zeigen:
- Fig 1:: einen Aufblick auf ein in einem fortlaufenden Band angebrachtes Stanzgitter mit elektrischen Bauteilen,
- Fig 2:: eine Seitenansicht der Anordnung nach Fig. 1, und
- Fig 3:: eine Seitenansicht eines Stanzgitters mit Abschnitten unterschiedlicher Dicke.

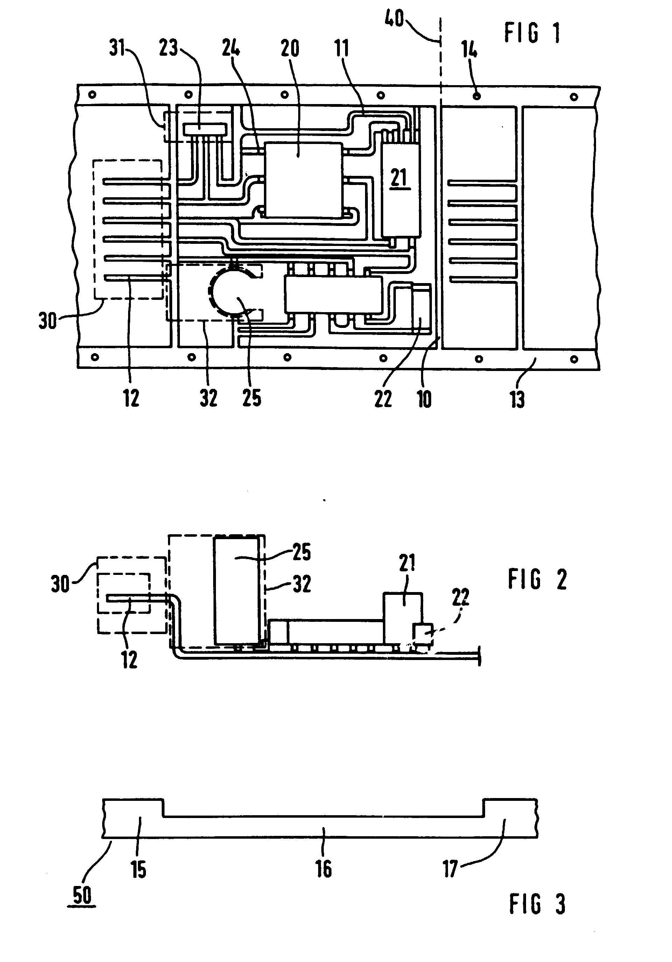

Fig. 1 zeigt ein Stanzgitter 10 mit Metallstreifen 11, die als Leiterbahnen zur Verbindung von elektrischen Bauelementen 20, 21, 22, 23, 25 dienen, welche auf dem Stanzgitter 10 angebracht - beispielsweise geklebt - sind. Die Bauelemente 20, 21, 22, 23, 25 sind beispielsweise als integrierte Schaltung 20, als Sensor 21, als Widerstand 22, als Kondensator 25 oder als Beschleunigungssensor 23 ausgebildet. Die Bauelemente sind über ihre Anschlußbeine 24 an das Stanzgitter 10 angeschweißt oder angelötet. Dabei können die Anschlußbeine entweder durch entsprechende Öffnungen des Stanzgitters 10 geführt und dann verlötet werden. Alternativ werden die Anschlußbeine derart umgebogen, daß sie auf der Oberfläche des Stanzgitters 10 verlötet werden können. Auch das Anbringen sogenannter "nackter" Chips ist möglich, wobei der Chipkörper beispielsweise durch Kleben auf dem Stanzgitter 10 befestigt wird und die einzelnen Anschlüsse zwischen Chip und Stanzgitter 10 über Bonddrähte hergestellt werden.

Teile des Stanzgitters 10 sind als Anschlußstifte 12 ausgebildet, die Bestandteil eines Steckerteils sind, mit dem das Gerät mit Kabeln oder anderen Schaltungen verbunden werden kann.

Das Stanzgitter 10 wird zum Schutz mit Kunststoff umspritzt, nachdem alle Bauelemente auf dem Stanzgitter 10 montiert und mit ihm elektrisch leitend verbunden sind. Damit ist das Stanzgitter 10 von einem fest mit ihm verbundenen Kunststoffgehäuse umgeben. In dieses Gehäuse werden beispielsweise eine Außentülle 30 für das Steckerteil, die die Anschlußstifte 12 umgibt, oder Halterungen 31, 32 für Bauteile, wie hier eine Halterung 31 für den Beschleunigungssensor 23 oder eine Halterung 32 für den Kondensator 25, miteingespritzt.

Zur gegenseitigen Fixierung von Leiterbahnen des Stanzgitters 10 werden zweckmäßigerweise auch die Bereiche 11 des Stanzgitters 10, die als Leiterbahnen dienen, mit Kunststoff umspritzt wodurch zusätzlich eine gute Isolation zwischen den Leiterbahnen auch unter ungünstigen Umständen, wie beispielsweise Nässe, gewährleistet ist und das Stanzgitter zusätzlich mechanische Festigkeit erhält.

Zur sogenannten Inline Fertigung, d.h. zur Fertigung am laufenden Band, wird ein langes Stanzgitterband, das eine Anzahl gleicher aneinandergehängter Stanzgitterstrukturen für eine Schaltungsanordnung enthält, mit in einem Randbereich 13 befindlichen Öffnungen 14 verwendet, mit denen das Band weitertransportiert werden kann. Diese Öffnungen 14 können so angeordnet sein, daß sie beim späteren Einbau des Geräts beispielsweise in den Motorraum eines Kraftfahrzeuges zur mechanischen Befestigung der Steuerschaltung an Trägerstrukturen dienen. Die Randbereiche 13 ragen dabei über eine eventuelle Kunststoffumhüllung hinaus. Die einzelnen Stanzgitter 10 werden nach der Bauteilmontage entlang der angedeuteten Linie 40 getrennt.

Wenn das Stanzgitter große Randbereiche 13 aufweist, die über den eigentlichen Bereich der Verbindungsstrukturen hinausreichen, so kann durch Umbiegen dieser Randbereiche 13 auch eine elektromagnetische Abschirmung erreicht werden. Diese Randbereiche 13 können auch als Kühlflächen dienen.

Wie insbesondere aus Fig. 2 deutlich wird, können Teile des Stanzgitters, wie zum Beispiel die Anschlußpins 12, auch in beliebige Richtungen gebogen werden, um das Steckerteil in einer definierten Höhe zur übrigen Schaltungsanordnung anzuordnen.

In Fig. 3 zeigt den Querschnitt durch ein Stanzgitter 10 mit unterschiedlich dicken Abschnitten. Der dickere Abschnitt 17 weist eine höhere mechanische Stabilität auf und kann beispielsweise zur mechanischen Befestigung des Stanzgitters 10 verwendet werden. Aus dem dickeren Abschnitt 15 können beispielsweise die Anschlußstifte 12 des Steckerteils gestanzt sein, wenn die Normung des Steckerteils dickere Anschlußstifte fordert. Für die eigentliche Leiterbahnen genügt eine geringere Dicke, wie sie hier im Mittelteil 16 angegeben ist.

Der Kontaktierbereich der Anschlußstifte 12, also der Teil des Metallbands, aus dem die Anschlußstifte 12 gestanzt werden, kann beispielsweise mit Gold 50 beschichtet sein, um korrosionsfreie Kontakte zu gewährleisten.

Man erhält somit ein Gerät mit einer Schaltungsanordnung auf einem Stanzgitter, das gegenüber Geräten mit herkömmlichen Leiterplatten folgende Vorteile aufweist: Das Stanzgitter aus Metall ist recyclingfreundlicher als eine übliche Leiterplatte, die sich aus verschiedenen Kunststoff- und Metallschichten zusammensetzt. Die elektrische Steckverbindung des Geräts ist zuverlässiger, da im Bereich des Steckerteils aufgrund der einstückigen Ausbildung der Anschlußstifte mit dem Stanzgitter Lötpunkte für das Verbinden separater Anschlußstifte mit dem Stanzgitter entfallen. Das Stanzgitter mit den elektrischen Bauteilen kann direkt mit einem schützenden Kunststoff umspritzt werden, sodaß die gestanzten Leiterbahnen auch unter ungünstigen Betriebsbedingungen, wie beispielsweise Nässe, eine zuverlässigere Isolierung gewährleisten als sie die auf einer Leiterplatte offen daliegenden Leiterbahnen bietet. Der umhüllende Kunststoff kann dabei zugleich das Gehäuse auch mit integriert angegossenen Steckerhüllen bilden, so daß Montageschritte eingespart werden, die sonst zur Montage von separaten Gehäuseteilen und Steckern notwendig wären. Durch das Umspritzen mit Kunststoff erhalten die Leiterbahnen auch einen mechanischen Halt. Nachdem das Stanzgitter durch ein zumindest teilweises Umspritzen mit Kunststoff die notwendige mechanische Festigkeit bekommen hat, werden Lücken in das Stanzgitter gestanzt. Durch diese Verbindung von Bereichen des Stanzgitters über Kunststoffbrücken werden Leiterbahnbereiche voneinander isoliert. Zudem weist das Stanzgitter dann eine hohe mechanische Stabilität auf.

## Patentansprüche

1. Gerät mit einer elektrischen Schaltungsanordnung, mit einem aus einem Metallband gestanzten Stanzgitter (10), das elektrische Bauelemente (20, 21, 22, 23, 25) elektrisch leitend miteinander verbindet, und mit einem Steckerteil mit Anschlußstiften (12), die als aus dem Metallband gestanzte Teile des Stanzgitters (10) ausgebildet sind, **dadurch gekennzeichnet,** daß das Stanzgitter (10) Randbereiche (13) aufweist, welche zur elektromagnetischen Abschirmung umgebogen sind.

2. Gerät nach Anspruch 1, dadurch gekennzeichnet, daß das Steckerteil ein Steckergehäuse aufweist und zumindest eine Außentülle (30) des Steckergehäuses aus Kunststoff hergestellt ist.

3. Gerät nach Anspruch 1, dadurch gekennzeichnet, daß das Stanzgitter (10) im Bereich der Anschlußstifte (12) dicker ausgebildet ist als im Bereich der elektrischen Bauelemente (21, 22, 23, 25).

4. Gerät nach Anspruch 1, dadurch gekennzeichnet, daß aus Kunststoff hergestellte Halterungen (31, 32) für elektrische Bauelemente (23, 25) auf dem Stanzgitter (10) angeordnet sind.

5. Gerät nach Anspruch 1, dadurch gekennzeichnet, daß zumindest Bereiche des Stanzgitters (10) über Kunststoffbrücken miteinander verbunden sind.

## Claims

1. Device having an electrical circuit arrangement, having a stamped grid (10) which is stamped from a metal strip and electrically conductively connects the electrical components (20, 21, 22, 23, 25) to one another, and having a plug part with connecting pins (12) which are designed as parts of the stamped grid (10) stamped out of the metal strip, characterized in that the stamped grid (10) has edge regions (13) which are bent around for electromagnetic screening.

2. Device according to Claim 1, characterized in that the plug part has a plug housing and at least one outer sleeve (30) of the plug housing is produced from plastic.

3. Device according to Claim 1, characterized in that the stamped grid (10) is designed to be thicker in the region of the connecting pins (12) than in the region of the electrical components (21, 22, 23, 25).

4. Device according to Claim 1, characterized in that holders (31, 32), produced from plastic, for electrical components (23, 25) are arranged on the stamped grid (10).

5. Device according to Claim 1, characterized in that at least regions of the stamped grid (10) are connected to one another via plastic lengths.

## Revendications

1. Dispositif à agencement de circuit électrique, comprenant une grille découpée (10), qui est découpée dans une bande métallique et qui relie des composants électriques (20, 21, 22, 23, 25) entre eux d'une manière électriquement conductrice, et une partie formant connecteur comportant des broches de connexion (12) qui sont réalisées sous forme de parties de la grille découpée (10) qui sont découpées dans la bande métallique, caractérisé en ce que le dispositif comprend les parties marginales (13) de la grille découpée qui sont repliées en vue du blindage électromagnétique.

2. Dispositif suivant la revendication 1, caractérisé en ce que la partie formant connecteur comporte un boîtier de connecteur et en ce qu'au moins un manchon extérieur (30) du boîtier de connecteur est réalisé en matière plastique.

3. Dispositif suivant la revendication 1, caractérisé en ce que la grille découpée (10) est plus épaisse dans la zone des broches de connexion (12) que dans la zone des composants électriques (21, 22, 23, 25).

4. Dispositif suivant la revendication 1, caractérisé en ce que des supports (31, 32) réalisés en matière plastique et destinés aux composants électriques (23,25) sont disposés sur la grille découpée (10).

5. Dispositif suivant la revendication 1, caractérisé en ce qu'au moins des parties de la grille découpée (10) sont reliées entre elles au moyen de ponts en matière plastique.
